# EUROPÄISCHE PATENTANMELDUNG

(11) **EP 4 575 523 A1**
(43) Veröffentlichungstag der Anmeldung: **25.06.2025**
(21) Anmeldenummer: 23218088.5
(22) Anmeldetag: 19.12.2023
(51) Int. Cl.: G01R 15/16, G01R 29/12

(54) **ELEKTRISCHE FELDMÜHLE ZUM ERFASSEN EINES ELEKTRISCHEN FELDES EINES LEITERS SOWIE VERFAHREN ZUM ERFASSEN EINES ELEKTRISCHEN FELDES**

(71) Anmelder: Siemens Aktiengesellschaft, 80333 München (DE)
(72) Erfinder: Raab, Oliver, 94496 Ortenburg (DE); Santos Wilke, Hans, 85599 Parsdorf (DE)
(74) Vertreter: Siemens Patent Attorneys

(57) **Zusammenfassung**

Die Erfindung betrifft eine elektrische Feldmühle (10) zum Erfassen eines elektrischen Feldes (E) eines Leiters (12), mit zumindest einem Sensorelement (14), wobei das Sensorelement (14) zumindest ein Feldverstärkungselement (24) aufweist. Ferner betrifft die Erfindung ein Verfahren zum Bestimmen eines elektrischen Felds (E).

## Beschreibung

Die Erfindung betrifft eine elektrische Feldmühle zum Erfassen eines elektrischen Feldes eines Leiters, mit zumindest einem Sensorelement gemäß dem geltenden Patentanspruch 1. Ferner betrifft die Erfindung ein Verfahren zum Bestimmen einer elektrischen Feldstärke eines elektrischen Feldes eines Leiters mittels einer elektrischen Feldmühle.

Bei einer elektrischen Feldmühle werden durch alternierende Abschirmung zweier Elektrodenflächen, insbesondere sogenannten Sensorflächen, gegen ein externes elektrisches Feld Ladungsträger verschoben. Durch Messung des Verschiebestroms kann so die elektrische Feldstärke des externen elektrischen Feldes bestimmt werden. Bei einem makroskopischen Aufbau der Feldmühle sind die Flächen der Elektroden um Größenordnungen größer als die Flächen der Zuleitungen zwischen Elektroden und der Messschaltung. Störsignale wie beispielsweise das Übersprechen vom Antrieb der Feldmühle oder ein Einkoppeln des externen Feldes über Flächen, welche durch den oben genannten Schirm nicht vollständig abgeschirmt sind, fallen so nicht wesentlich ins Gewicht.

Das Funktionsprinzip ist insbesondere als sogenanntes MEMS-Voltmeter mit mikroelektromechanischen Bauteilen umgesetzt. Bei einer solchen mikroelektromechanischen Feldmühle hingegen liegen Flächen der Elektroden und der Verschaltung in einer Größenordnung, weshalb eine Schirmung dieser essentiell ist. Gleichzeitig schwächt nahezu jede Art der Abschwächung von Störsignalen, insbesondere durch Abschirmung oder Vergrößerung des Abstands zum Messobjekt, zugleich auch das eigentlich zu messende Feld und dessen Wirken auf die Sensorflächen der Feldmühle ein. Das eigentliche Messsignal wird also schwächer. Die Sensorflächen mit der mikroelektromechanischen Feldmühle sind im Vergleich mit einer makroskopischen Feldmühle deutlich kleiner.

Die elektromechanische Feldmühle bietet nur geringe Flächen zum Einfangen des elektrischen Feldes und zeigt daher nur eine geringe Sensitivität. Eine Erhöhung der Sensitivität kann durch hohe Frequenzen des Shutters erreicht werden.

Interessiert man sich jedoch nicht nur für die Feldstärke, sondern insbesondere für die Spannung des Objekts, welches das Feld erzeugt, so verringert sich das Signal, insbesondere äquivalent zur Feldstärke, mit dem Abstand. Es ist daher praktikabel, den Abstand so gering wie möglich zu halten.

Aufgabe der vorliegenden Erfindung ist es, eine elektrische Feldmühle sowie ein Verfahren zu schaffen, mittels welchen ein elektrisches Feld beziehungsweise eine Spannung eines Leiters bestimmt werden kann.

Diese Aufgabe wird durch eine elektrische Feldmühle sowie durch ein Verfahren gemäß den unabhängigen Patentansprüchen gelöst. Vorteilhafte Ausgestaltungsformen sind in den Unteransprüchen angegeben.

Ein Aspekt der Erfindung betrifft eine elektrische Feldmühle zum Erfassen eines elektrischen Feldes eines Leiters, mit zumindest einem Sensorelement.

Dabei ist vorgesehen, dass das Sensorelement zumindest ein Feldverstärkungselement aufweist.

Insbesondere ist somit vorgesehen, dass innerhalb des Sensorelements das erfasste Feld verstärkt wird und dadurch dann beispielsweise über die Sensorflächen entsprechend erfasst werden kann. Somit kann verbessert das elektrische Feld bestimmt werden, wobei im Anschluss daran beispielsweise die Spannung auf Basis eines Abstands zum elektrischen Leiter sowie des elektrischen Felds bestimmt werden kann.

Insbesondere, da die elektrische Feldmühle, welche insbesondere als MEMS-Feldmühle ausgebildet ist, beispielsweise mit ihren Sensorflächen aus technischen und/oder praktischen Gründen nicht beliebig nahe an das Objekt mit der zu bestimmenden Spannung herangeführt werden kann, ist die Erfindung vorteilhaft einzusetzen. Beispielsweise aus Sicherheitsgründen aufgrund hoher Spannungen oder schlicht, weil sich andere Bauteile im Weg befinden und der Verbund aus MEMS und Schaltungsträger nicht näher herangeführt werden kann, ist die Erfindung vorteilhaft.

Es ist nun erfindungsgemäß vorgesehen, dass das elektrische Feld speziell im Bereich des MEMS-Bauteils mittels eines passiven Bauteils verstärkt wird. Das Funktionsprinzip ist dabei insbesondere analog zu der Funktionsweise von Kondensatoren mit einem Dielektrikum oder anderen isolierenden Stoffen. Das Material isoliert, verstärkt aber die Kapazität des Kondensators um den Faktor einer relativen Permittivität εᵣ des isolierenden Stoffes. Der Faktor geht direkt, insbesondere proportional, mit ein. Über die MEMS-Feldmühle bedeutet eine Erhöhung der Kapazität eine Verstärkung der Felddichte des vom Messobjekt ausgehenden elektrischen Feldes im Bereich des MEMS-Bauteils und seiner Sensorflächen. So kann das Messsignal verstärkt werden, ohne das Gesamtbauteil weiter an das Messobjekt, insbesondere dem Leiter, heranzuführen.

Insbesondere besteht somit der wesentliche Unterschied zum Stand der Technik darin, dass die Sensorflächen des Sensorelements nicht näher an den Leiter herangebracht werden, sondern ein weiterer Stoff eingebracht wird, welcher das elektrische Feld entsprechend verstärkt.

Gemäß einer vorteilhaften Ausgestaltungsform ist das Feldverstärkungselement als ein Dielektrikum ausgebildet. Insbesondere weist das Dielektrikum eine entsprechende Permittivität εᵣ auf. Auf Basis des Dielektrikums kann somit das elektrische Feld zuverlässig verstärkt werden. Somit kann ein verbesserter Betrieb der elektrischen Feldmühle realisiert werden.

Eine weitere vorteilhafte Ausgestaltungsform sieht vor, dass das Feldverstärkungselement an einer äußeren Seite des Sensorelements, welche dem Leiter zugewandt ist, ausgebildet ist. Insbesondere ist somit das Feldverstärkungselement bei einer entsprechenden Anordnung mit dem Leiter zwischen dem Leiter und dem Sensorelement angeordnet. Das Feldverstärkungselement ist somit in einem beziehungsweise an einem Messbereich der elektrischen Feldmühle ausgebildet. Somit kann das elektrische Feld vom Leiter hin zum Sensorelement entsprechend verstärkt werden.

In einer weiteren vorteilhaften Ausgestaltungsform ist vorgesehen, dass das Feldverstärkungselement an einer Shuttereinrichtung des Sensorelements ausgebildet ist. Beispielsweise kann der Shutter zwei entsprechende Shutterflächen aufweisen. Insbesondere kann dann beispielsweise zwischen den Shutterflächen, beispielsweise dann auch mit beweglich, das Feldverstärkungselement angeordnet sein. Somit ist es ermöglicht, dass das Verstärkungselement zuverlässig innerhalb des Sensorelements bereitgestellt werden kann.

Ebenfalls vorteilhaft ist, wenn das Feldverstärkungselement zwischen zumindest einer Sensorfläche des Sensorelements und einer Shuttereinrichtung des Sensorelements ausgebildet ist. Insbesondere ist somit das Feldverstärkungselement zwischen der Sensorfläche und der Shuttereinrichtung ausgebildet sein. Insbesondere kann somit eine Feldverstärkung zwischen der Shuttereinrichtung und der Sensorfläche realisiert werden. Somit können entsprechende Bauräume innerhalb der Feldmühle genutzt werden, um das elektrische Feld zuverlässig verstärken zu können. Entsprechende Bauräume werden somit vorteilhaft ausgenutzt.

Eine weitere vorteilhafte Ausgestaltungsform sieht vor, dass die elektrische Feldmühle eine elektronische Recheneinrichtung aufweist, wobei beim Bestimmen des elektrischen Felds mittels der elektronischen Recheneinrichtung eine relative Permittivität des Feldverstärkungselements berücksichtigt ist. Insbesondere kann somit beispielsweise die relative Permittivität innerhalb der elektronischen Recheneinrichtung abgespeichert werden. Somit kann zuverlässig das elektrische Feld verstärkt werden und dann auf Basis der Berücksichtigung wiederum berücksichtigt werden, um zuverlässig das tatsächliche elektrische Feld und somit die tatsächliche Spannung am Leiter bestimmen zu können.

Ebenfalls vorteilhaft ist, wenn die elektrische Feldmühle eine elektronische Recheneinrichtung aufweist, wobei beim Bestimmen des elektrischen Felds mittels der elektronischen Recheneinrichtung ein Abstand zwischen dem Feldverstärkungselement und einer Sensorfläche des Sensorelements berücksichtigt ist. Insbesondere kann somit der Abstand zwischen dem Feldverstärkungselement, welcher auch als Feldkonzentrator bezeichnet werden kann, und den entsprechenden Sensorflächen berücksichtigt werden. Somit kann verbessert auf das tatsächliche elektrische Feld und die Spannung im Leiter rückgeschlossen werden.

Eine weitere vorteilhafte Ausgestaltungsform sieht vor, dass die elektrische Feldmühle eine elektronische Recheneinrichtung aufweist, wobei beim Bestimmen des elektrischen Felds mittels der elektronischen Recheneinrichtung ein Abstand zwischen dem Feldverstärkungselement und dem Leiter berücksichtigt ist. Insbesondere, sollte beispielsweise das Feldverstärkungselement nicht direkt an dem Leiter aufliegen, so kann auch der Abstand entsprechend berücksichtigt werden. Auf Basis des Abstands kann dann zuverlässig auf das elektrische Feld rückgeschlossen werden beziehungsweise kann mittels des Abstands auf Basis des elektrischen Felds auf die Spannung rückgeschlossen werden. Somit kann zuverlässig die Spannung innerhalb des Leiters, insbesondere berührungslos, bestimmt werden.

In einer weiteren vorteilhaften Ausgestaltungsform ist vorgesehen, dass das Feldverstärkungselement im Wesentlichen zylinderförmig ausgebildet ist. Insbesondere kann somit das Feldverstärkungselement als eine Art Verlängerung der Sensorflächen ausgebildet sein und entsprechend an den Leiter gebracht werden. Somit kann ein einfaches Feldverstärkungselement bereitgestellt werden.

Ferner hat es sich als vorteilhaft erwiesen, wenn das Feldverstärkungselement im Wesentlichen konusförmig ausgebildet ist. Insbesondere kann somit eine Art Trichter geschaffen werden. Insbesondere kann somit ein größerer Teil des elektrischen Feldes am Leiter "eingefangen" werden und konusförmig hin zum Sensorelement beziehungsweise die Sensorfläche gebracht werden. Somit kann noch genauer das elektrische Feld erfasst werden.

Dabei sieht eine vorteilhafte Ausgestaltungsform vor, dass das Feldverstärkungselement mit einer spitzen Seite des Konus in Richtung einer Sensorfläche des Sensorelements angeordnet ist. Der Konus ist dabei insbesondere entsprechend an der Stelle, an welcher dieser auf die Sensorflächen trifft, abgeflacht und weist insbesondere die Größe der Sensorfläche auf. Mit der größeren Seite des Konus ist somit das Feldverstärkungselement insbesondere in Richtung des Leiters ausgebildet. Somit kann das elektrische Feld entsprechend zuverlässig erfasst werden. Insbesondere kann somit die Fläche des Feldverstärkungselements zum Messobjekt hin vergrößert werden und spitz auf die Sensorflächen zulaufen.

Es hat sich weiterhin als vorteilhaft erwiesen, wenn das Feldverstärkungselement mit einer spitzen Seite des Konus in Richtung einer Sensorfläche des Sensorelements angeordnet ist. Somit kann das elektrische Feld entsprechend zuverlässig erfasst werden. Insbesondere kann somit die Fläche des Feldverstärkungselements zum Messobjekt hin vergrößert werden und spitz auf die Sensorflächen zulaufen.

Eine weitere vorteilhafte Ausgestaltungsform sieht vor, dass das Feldverstärkungselement elektrisch isolierend ausgebildet ist. Insbesondere ist das Feldverstärkungselement zumindest elektrisch isolierend gegenüber den Sensorflächen ausgebildet. Somit können entsprechende Störeinflüsse auf die Sensorflächen verhindert werden.

In einer weiteren vorteilhaften Ausgestaltungsform ist vorgesehen, dass das Feldverstärkungselement als ein elektrischer Leiter ausgebildet ist. Somit kann auf einfache Art und Weise ein Feldverstärkungselement bereitgestellt werden.

Dabei kann ferner vorgesehen sein, dass das Feldverstärkungselement floatend zu der Sensorfläche des Sensorelements isoliert ist. Insbesondere ist somit das Sensorelement und elektrisch Feldverstärkungselement zueinander elektrisch isoliert. Dabei kann ferner vorgesehen sein, dass das Feldverstärkungselement hochohmig ausgebildet ist und mit einer elektrischen Masse des Sensorelements gekoppelt ist, so dass sich kein Potential auf dem Leiter ausbilden kann.

Ein weiterer Aspekt der Erfindung betrifft ein Verfahren zum Bestimmen eines elektrischen Feldes eines Leiters mittels einer elektrischen Feldmühle nach dem vorhergehenden Aspekt. Es erfolgt das Verstärken des elektrischen Feldes mittels des Feldverstärkungselements. Es wird das verstärkte Feld mittels zumindest einer Sensorfläche des Sensorelements erfasst. Es wird das elektrische Feld auf Basis des verstärkten Feldes unter Berücksichtigung einer relativen Permittivität des Feldverstärkungselements mittels einer elektronischen Recheneinrichtung der elektrischen Feldmühle bestimmt.

Dabei kann es sich zumindest teilweise um ein computer-implementiertes Verfahren handeln, welches insbesondere mittels der elektronischen Recheneinrichtung durchgeführt werden kann. Hierzu weist die elektronische Recheneinrichtung beispielsweise ein Computerprogrammprodukt mit Programmcodemitteln auf, welche die elektronische Recheneinrichtung dazu veranlassen, wenn die Programmcodemittel von der elektronischen Recheneinrichtung abgearbeitet werden, ein Verfahren entsprechend durchzuführen. Daher betrifft ein weiterer Aspekt der Erfindung auch ein computerlesbares Speichermedium mit dem entsprechenden Computerprogrammprodukt.

Vorteilhafte Ausgestaltungsformen der elektrischen Feldmühle sind als vorteilhafte Ausgestaltungsformen des Verfahrens, des Computerprogrammprodukts, des computerlesbaren Speichermediums sowie auch der elektronischen Recheneinrichtung anzusehen.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCR_AM (englisch: "phase-change random access memory"), ausgestaltet sein.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- FIG 1: ein schematisches Blockschaltbild gemäß einer Ausführungsform einer elektrischen Feldmühle;
- FIG 2: eine schematische Seitenansicht einer Ausführungsform einer elektrischen Feldmühle; und
- FIG 3: eine weitere schematische Seitenansicht einer Ausführungsform einer elektrischen Feldmühle.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

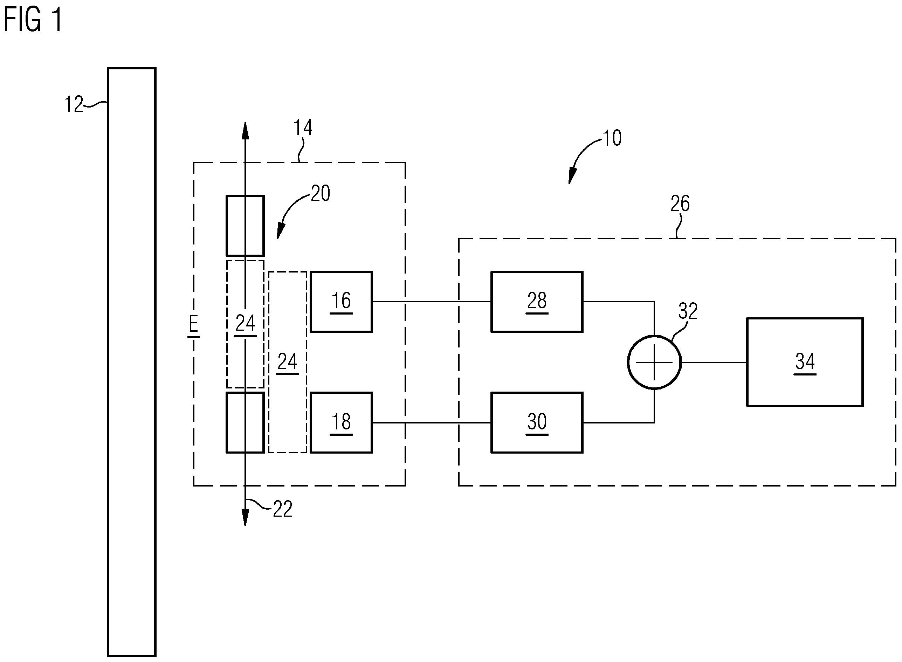

FIG 1 zeigt ein schematisches Blockschaltbild einer Ausführungsform einer elektrischen Feldmühle 10. Die elektrische Feldmühle 10 ist zum Bestimmen eines elektrischen Felds E eines Leiters 12 ausgebildet. Insbesondere ist ein berührungsloses Bestimmen einer Spannung im Leiter 12 über die elektrische Feldmühle 10 ermöglicht. Die elektrische Feldmühle 10 weist hierzu ein Sensorelement 14 auf. Im folgenden Ausführungsbeispiel weist das Sensorelement 14 eine erste Sensorfläche 16 sowie eine zweite Sensorfläche 18 auf. Ferner ist insbesondere eine Shuttereinrichtung 20 gezeigt, welche eine Bewegung 22 vollzieht.

Die Bewegung 22 kann dabei insbesondere sinusförmig ausgebildet sein.

Die FIG 1 zeigt ferner, dass das Sensorelement 14 zumindest ein Feldverstärkungselement 24 aufweisen kann.

Im folgenden Ausführungsbeispiel ist ein Feldverstärkungselement 24 an der Shuttereinrichtung 20 ausgebildet und ein weiteres Feldverstärkungselement 24 zwischen der Shuttereinrichtung 20 und den Sensorflächen 16, 18.

Die FIG 1 zeigt ferner, dass die erste Sensorfläche 16 und die zweite Sensorfläche 18 mit einer elektronischen Recheneinrichtung 26 der elektrischen Feldmühle 10 gekoppelt sind. Die elektronische Recheneinrichtung 26 kann hierzu beispielsweise einen ersten I/U-Wandler 28 aufweisen, welcher insbesondere mit der ersten Sensorfläche 16 gekoppelt ist. Ferner weist die elektronische Recheneinrichtung 26 einen zweiten I/U-Wandler 30 auf, welcher insbesondere mit der zweiten Sensorfläche 28 in Kontakt steht. Die beiden I/U-Wandler 28, 30 werden in einem Additionselement 32 entsprechend addiert und einem Analog-Signalwandler 34 zugeführt.

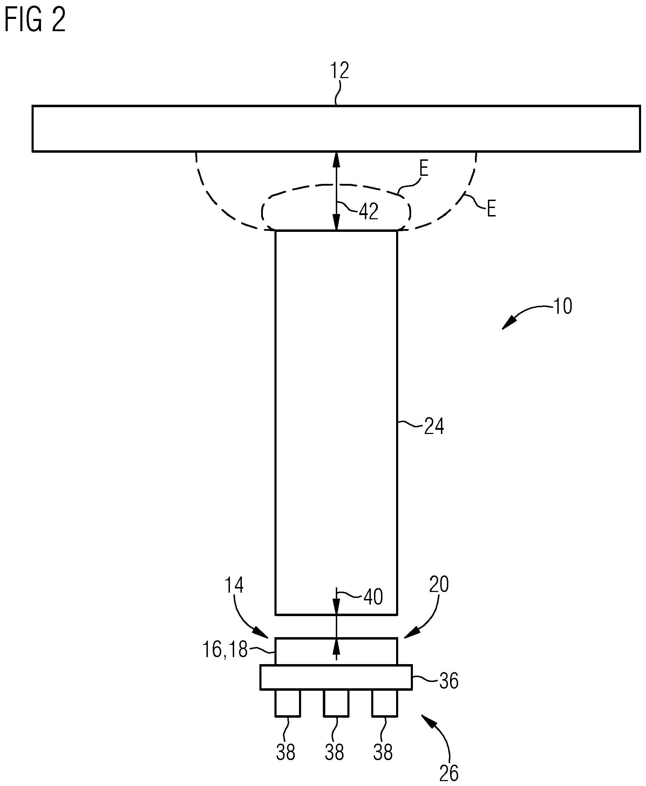

Die FIG 2 zeigt eine schematische Seitenansicht einer Ausführungsform einer elektrischen Feldmühle 10. Im folgenden Ausführungsbeispiel ist das Feldverstärkungselement 24 zwischen dem Leiter 12 und den Sensorflächen 16, 18 ausgebildet. Ferner kann beispielsweise in dem Bauteil mit den Sensorflächen 16, 18 die Shuttereinrichtung 20 ausgebildet sein.

Das Feldverstärkungselement 24 kann dabei insbesondere als ein Dielektrikum ausgebildet sein. Des Weiteren zeigt die FIG 2, dass das Feldverstärkungselement 24 an einer äußeren Seite des Sensorelements 14 ausgebildet ist, welche dem Leiter 12 zugewandt ist.

Die FIG 2 zeigt ferner, dass beispielsweise die elektronische Recheneinrichtung 26 auf Basis einer Leiterplatte 36 und weiteren elektronischen Bauteilen 38 ausgebildet ist. Dabei kann das Sensorelement 14 direkt auf der Leiterplatte 26 ausgebildet sein. Im vorliegenden Ausführungsbeispiel ist insbesondere zwischen zumindest den Sensorflächen 16, 18 und dem Feldverstärkungselement 24 ein Abstand 40 ausgebildet. Dieser Abstand 40 kann von der elektronischen Recheneinrichtung 26 entsprechend berücksichtigt werden. Ferner kann beim Bestimmen des elektrischen Felds E mittels der elektronischen Recheneinrichtung 26 eine relative Permittivität des Feldverstärkungselements 24 berücksichtigt werden. Des Weiteren kann vorgesehen sein, dass beim Bestimmen des elektrischen Felds E mittels der elektronischen Recheneinrichtung 26 auch ein Abstand 42 zwischen dem Feldverstärkungselement 24 und dem Leiter 12 berücksichtigt werden kann.

Die FIG 2 zeigt ferner, dass das Feldverstärkungselement 24 im Wesentlichen zylinderförmig ausgebildet ist.

Insbesondere ist somit vorgesehen, dass beispielsweise die elektrische Feldmühle 10 mit den Sensorflächen 16, 18 aus technischen und/oder praktischen Gründen nicht beliebig nahe an den Leiter 12 mit der zu bestimmenden Spannung herangeführt werden kann. Beispielsweise aus Sicherheitsgründen aufgrund von hoher Spannungen oder schlicht, weil sich andere Bauteile im Weg befinden und der Verbund aus den Sensorflächen 16, 18 und beispielsweise der Leiterplatte 36 nicht näher herangeführt werden kann.

Dabei ist nun insbesondere vorgesehen, dass das elektrische Feld E speziell im Bereich des Sensorelements 14 mittels eines passiven Bauteils verstärkt wird. Dies kann beispielsweise ein Dielektrikum sein. Das Funktionsprinzip ist dabei analog zu der Funktionsweise von den Kondensatoren mit Dielektrikum oder anderen isolierenden Stoffen. Das Material isoliert, verstärkt dabei die Kapazität des Kondensators um den Faktor der relativen Permittivität εᵣ des isolierenden Stoffes. Der Faktor geht direkt proportional ein. Übertragen auf die elektrische Feldmühle 10 bedeutet eine Erhöhung der Kapazität eine Verstärkung der Felddichte des vom Leiter 12 ausgehenden elektrischen Feldes E im Bereich des Sensorelements 14 und der entsprechenden Sensorflächen 16, 18. So kann das Messsignal verstärkt werden, ohne das Gesamtbauteil weiter an den Leiter 12 heranzuführen. Eine solche Anordnung ist in der FIG 2 dargestellt.

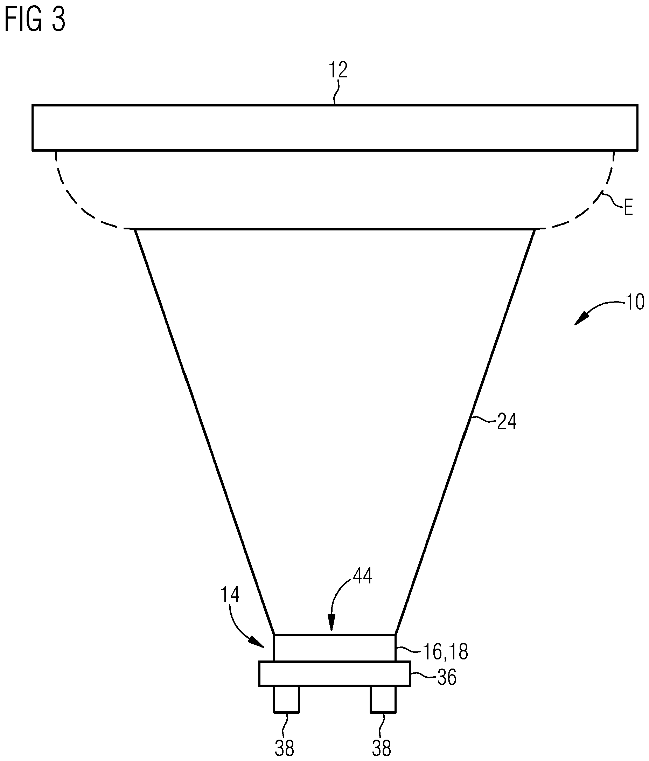

FIG 3 zeigt eine weitere schematische Seitenansicht einer Ausführungsform einer elektrischen Feldmühle 10. Im folgenden Ausführungsbeispiel ist insbesondere gezeigt, dass das Feldverstärkungselement 24 im Wesentlichen konusförmig ausgebildet ist. Dabei ist insbesondere gezeigt, dass das Feldverstärkungselement 24 mit einer spitzen Seite 44 des Konus in Richtung der Sensorfläche 16, 18 des Sensorelements 14 angeordnet ist.

Ferner kann insbesondere vorgesehen sein, dass das Feldverstärkungselement 24 elektrisch isolierend ausgebildet ist. Dabei zeigt die FIG 3 ferner, dass das Feldverstärkungselement 24 auch direkt mit den Sensorflächen 16, 18 beziehungsweise der Shuttereinrichtung 20 in Kontakt stehen kann.

Insbesondere kann somit vorgesehen sein, dass neben der relativen Permittivität εᵣ auch weitere Einflussfaktoren berücksichtigt werden. Insbesondere der Abstand 42 zwischen dem Feldverstärkungselement 24 und dem Leiter 12 sowie der Abstand 40 zwischen dem Feldverstärkungselement 24 und den Sensorflächen 16, 18 kann dabei berücksichtigt werden. Besonders vorteilhaft ist, wenn mittels des Feldverstärkungselements 24, insbesondere wie in FIG 3 gezeigt, das Sensorelement 14 beziehungsweise die Sensorflächen 16, 18 mithilfe des Feldverstärkungselements 24 geschlossen werden, sodass die innenliegenden beweglichen Bauteile gegenüber Staubpartikeln und ähnlichem geschützt sind. Weiterhin vorteilhaft ist, wenn die Fläche des Feldverstärkungselements 24 sich zum Leiter 12 hin vergrößert, und spitz auf die Spiegelflächen 16, 18 zuläuft.

Auch im Kontext der oben erwähnten Schirmung der weiteren Elektronik gegenüber dem Leiter 12 ist dies von Bedeutung. Der Einsatz eines solchen passend auf das Messteil beziehungsweise auf die Leiter 12 aufgesetzten Feldverstärkungselements 24 verstärkt dieses nur im Bereich der Sensorflächen 16, 18 wesentlich. Nicht jedoch im Bereich der Leiterplatte 36 und damit der weiteren Schaltung, neben dem unter dem Bauteil der Sensorflächen 16, 18. Zwar sind diese Einflüsse möglich, können aber durch weitere Optimierung der Geometrie des Feldverstärkungselements 24 reduziert beziehungsweise optimiert werden. Würde stattdessen das Bauteil selbst näher an den Leiter 12 herangebracht werden, würden die Mess- und Störsignale gleichermaßen verstärkt werden.

Anstelle eines Isolators mit möglichst hoher relativer Permittivität funktioniert das Prinzip auch mit einem elektrischen Leiter, insbesondere Metall, welcher floatend, von den Sensorflächen 16, 18 elektrisch isoliert, angebunden ist.

### Bezugszeichenliste

- 10: elektrische Feldmühle
- 12: Leiter
- 14: Sensorelement
- 16: erste Sensorfläche
- 18: zweite Sensorfläche
- 20: Shuttereinrichtung
- 22: Bewegung
- 24: Feldverstärkungselement
- 26: elektronische Recheneinrichtung
- 28: erster I/U-Wandler
- 30: zweiter I/U-Wandler
- 32: Additionselement
- 34: Analogsignalwandler
- 36: Leiterplatte
- 38: elektronisches Bauteil
- 40: Abstand
- 42: Abstand
- 44: spitze Seite
- E: elektrisches Feld

## Patentansprüche

1. Elektrische Feldmühle (10) zum Erfassen eines elektrischen Feldes (E) eines Leiters (12), mit zumindest einem Sensorelement (14),
**dadurch gekennzeichnet, dass**
das Sensorelement (14) zumindest ein Feldverstärkungselement (24) aufweist.

2. Elektrische Feldmühle (10) nach Anspruch 1, **dadurch gekennzeichnet, dass**
das Feldverstärkungselement (24) als ein Dielektrikum ausgebildet ist.

3. Elektrische Feldmühle (10) nach Anspruch 1 oder 2, **dadurch gekennzeichnet, dass**
das Feldverstärkungselement (24) an einer äußeren Seite des Sensorelements (14), welche dem Leiter (12) zugewandt ist, ausgebildet ist.

4. Elektrische Feldmühle (10) nach einem der vorhergehenden Ansprüchen, **dadurch gekennzeichnet, dass**
das Feldverstärkungselement (24) an einer Shuttereinrichtung (20) des Sensorelements (14) ausgebildet ist.

5. Elektrische Feldmühle (10) nach einem der vorhergehenden Ansprüchen, **dadurch gekennzeichnet, dass**
das Feldverstärkungselement (24) zwischen zumindest einer Sensorfläche (16, 18) des Sensorelements (14) und an einer Shuttereinrichtung (20) des Sensorelements (14) ausgebildet ist.

6. Elektrische Feldmühle (10) nach einem der vorhergehenden Ansprüchen, **dadurch gekennzeichnet, dass**
die elektrische Feldmühle (10) eine elektronische Recheneinrichtung (26) aufweist, wobei beim Bestimmen des elektrischen Felds (E) mittels der elektronischen Recheneinrichtung (26) eine relativen Permittivität des Feldverstärkungselements (24) berücksichtigt ist.

7. Elektrische Feldmühle (10) nach einem der vorhergehenden Ansprüchen, **dadurch gekennzeichnet, dass**
die elektrische Feldmühle (10) eine elektronische Recheneinrichtung (26) aufweist, wobei beim Bestimmen des elektrischen Felds (E) mittels der elektronischen Recheneinrichtung (26) ein Abstand (40) zwischen dem Feldverstärkungselement (24) und einer Sensorfläche (16, 18) des Sensorelements (14) berücksichtigt ist.

8. Elektrische Feldmühle (10) nach einem der vorhergehenden Ansprüchen, **dadurch gekennzeichnet, dass**
die elektrische Feldmühle (10) eine elektronische Recheneinrichtung (26) aufweist, wobei beim Bestimmen des elektrischen Felds (E) mittels der elektronischen Recheneinrichtung (26) ein Abstand (42) zwischen dem Feldverstärkungselement (24) und dem Leiter (12) berücksichtigt ist.

9. Elektrische Feldmühle (10) nach einem der vorhergehenden Ansprüchen, **dadurch gekennzeichnet, dass**
das Feldverstärkungselement (24) im Wesentlichen zylinderförmig ausgebildet ist.

10. Elektrische Feldmühle (10) nach einem der Ansprüche 1 bis 8, **dadurch gekennzeichnet, dass**
das Feldverstärkungselement (24) im Wesentlichen konusförmig ausgebildet ist.

11. Elektrische Feldmühle (10) nach Anspruch 10, **dadurch gekennzeichnet, dass**
das Feldverstärkungselement (24) mit einer spitzen Seite (44) des Konus in Richtung einer Sensorfläche (16,18) des Sensorelements (14) angeordnet ist.

12. Elektrische Feldmühle (10) nach einem der vorhergehenden Ansprüche, **dadurch gekennzeichnet, dass**
das Feldverstärkungselement (24) elektrisch isolierend ausgebildet ist.

13. Elektrische Feldmühle (10) nach einem der vorhergehenden Ansprüche, **dadurch gekennzeichnet, dass**
das Feldverstärkungselement (24) als ein elektrischer Leiter ausgebildet ist.

14. Elektrische Feldmühle (10) nach Anspruch 13, **dadurch gekennzeichnet, dass**
das Feldverstärkungselement (24) floatend zu der Sensorfläche (16, 18) des Sensorelements (14) isoliert ist.

15. Verfahren zum Bestimmen eines elektrischen Feldes (E) eines Leiters (12) mittels einer elektrischen Feldmühle (10) nach einem der Ansprüche 1 bis 14, mit den Schritten:
- Verstärken des elektrischen Feldes (E) mittels des Feldverstärkungselements (24);
- Erfassen des verstärkten Feldes mittels zumindest einer Sensorfläche (16, 18) des Sensorelements (14);
- Bestimmen des elektrischen Feldes (E) auf Basis des verstärkten Feldes unter Berücksichtigung einer relativen Permittivität des Feldverstärkungselements (24) mittels einer elektronischen Recheneinrichtung (26) der elektrischen Feldmühle (10).
